# DEMANDE DE BREVET EUROPEEN

(11) **EP 1 437 827 A1**
(43) Date de publication de la demande: **14.07.2004**
(21) Numéro de dépôt: 03290065.6
(22) Date de dépôt: 10.01.2003
(51) Int. Cl.: H03F 3/217, H03F 3/21

(54) **Dispositif d'amplification de puissance, en particulier pour un téléphone mobile cellulaire**

(71) Demandeur: STMicroelectronics N.V., 1077 XX Amsterdam (NL); STMicroelectronics S.r.l., 20041 Agrate Brianza (Milano) (IT)
(72) Inventeur: Cerisier, Patrick, 74350 Copponex (FR); Cesura, Giovanni, 26100 Cremona (IT)
(74) Mandataire: Casalonga, Axel

(57) **Abrégé**

Le dispositif d'amplification de puissance, comporte une entrée pour recevoir un signal ayant une bande fréquentielle utile (BE), et des moyens d'amplification de puissance du type delta-sigma (MAP). Les moyens d'amplification de puissance du type delta-sigma (MAP) présentent un ordre supérieur ou égal à un dans la bande utile du signal et un ordre supérieur ou égal à un hors de ladite bande utile.

## Description

L'invention concerne l'amplification de puissance, notamment mais non exclusivement celle utilisée dans les systèmes de communication sans fil, en particulier au sein des téléphones mobiles cellulaires.

Dans un système de communication sans fil, une station de base communique avec une pluralité de terminaux distants, tels que des téléphones mobiles cellulaires. Les accès multiples par division de fréquence (FDMA : « Frequency-Division Multiple Access » en langue anglaise) et les accès multiples par division temporelle (TDMA : « Time Division Multiple Access » en langue anglaise) sont les schémas d'accès multiples traditionnels pour délivrer des services simultanés à un certain nombre de terminaux. L'idée de base sous-jacente aux systèmes FDMA et TDMA consiste à partager la ressource disponible, respectivement en plusieurs fréquences ou en plusieurs intervalles temporels, de telle sorte que plusieurs terminaux peuvent fonctionner simultanément sans provoquer d'interférence.

A l'opposé de ces schémas utilisant une division de fréquence ou une division temporelle, les schémas CDMA permettent aux utilisateurs multiples de partager une fréquence commune et un tel canal temporel commun en utilisant une modulation codée.

Plus précisément, comme il est bien connu par l'homme du métier, un code d'embrouillage (« scrambling code » en langue anglaise) est associé à chaque station de base et permet de distinguer une station de base d'une autre. En outre, un code orthogonal, connu par l'homme du métier sous la dénomination de « Code OVSF », est alloué à chaque terminal distant (comme par exemple un téléphone mobile cellulaire). Tous les codes OVSF sont orthogonaux entre eux, ce qui permet de distinguer un terminal distant d'un autre.

Avant d'émettre un signal sur le canal de transmission à destination d'un terminal distant, le signal a été embrouillé et étalé (« spread » en langue anglaise) par la section de base en utilisant le code d'embrouillage de la station de base et le code OVSF du terminal distant.

Dans les systèmes CDMA, on peut encore distinguer ceux qui utilisant une fréquence distincte pour l'émission et la réception (système CDMA-FDD) et ceux qui utilisent une fréquence commune pour l'émission et la réception, mais des domaines temporels distincts pour l'émission et la réception (système CDMA-TDD).

Les terminaux, tels que les téléphones mobiles cellulaires, de troisième génération doivent être compatibles avec la norme UMTS, c'est-à-dire qu'ils doivent être capables de fonctionner sous différentes normes de transmissions sans fil. Ainsi, ils devront être capables de fonctionner dans un système du type FDMA/TDMA, selon par exemple la norme de transmission GSM ou GPRS, ou encore dans des systèmes de communication du type CDMA-FDD ou CDMA-TDD, en utilisant par exemple les normes de transmission UTRA-FDD ou UTRA-TDD ou IS-95.

L'invention s'applique ainsi notamment à tous les terminaux ou composants de systèmes de communication sans fil, par exemple les téléphones mobiles cellulaires, quelle que soit la norme de transmission utilisée, que celle-ci prévoit une modulation à enveloppe constante (systèmes GSM et DCS, par exemple) ou variable (systèmes du type CDMA), bien que l'invention soit particulièrement avantageuse pour les systèmes à modulation à enveloppe variable.

La chaîne d'émission radiofréquence d'un composant d'un système de communication sans fil, par exemple un téléphone mobile cellulaire, comporte un amplificateur de puissance destiné à amplifier le signal à un niveau suffisant pour pouvoir le transmettre. Dans les systèmes fonctionnant selon la norme CDMA, qui présentent une modulation à enveloppe variable, on utilise une chaîne d'émission linéaire qui permet de retransmettre sans distorsion l'amplitude du signal.

Une solution pour réaliser les moyens d'amplification de puissance de la chaîne d'émission consiste à utiliser des moyens d'amplification du type delta-sigma. Un exemple d'une telle architecture est par exemple décrit dans le brevet américain n° 5 777 512.

Des moyens d'amplification du type delta-sigma présentent intrinsèquement l'avantage d'être plus compétitifs en terme d'efficacité que des moyens d'amplification linéaires classiques.

Cependant, l'utilisation de moyens d'amplification du type delta-sigma présente des inconvénients que l'on va maintenant exposer.

De tels moyens d'amplification comportent des réseaux sélecteurs de fréquences qui permettent d'ajuster la position des zéros de la fonction de transfert de bruit, c'est-à-dire d'ajuster les fréquences auxquelles le bruit de quantification est en théorie éliminé. Et, traditionnellement, ces zéros sont placés dans la bande utile de transmission dans laquelle le signal se situe, de façon à respecter le rapport signal/bruit requis par la norme de transmission utilisée.

Et, puisque la majeure partie du bruit de quantification est repoussée hors de la bande utile du signal, il est alors nécessaire de prévoir en sortie des moyens d'amplification de type delta-sigma, un ou plusieurs filtres post-amplificateurs dont la fonction consiste notamment à éliminer le bruit de quantification situé en dehors de la bande de signal utile. Il est en effet nécessaire de respecter des gabarits de bruit définis par les normes de transmission, et prévoyant qu'en dehors de la bande utile du signal, le bruit ne doit pas dépasser un certain niveau d'énergie, afin de ne pas perturber d'autres émissions/réceptions qui utiliseraient des normes de transmission différentes.

Or, si, pour satisfaire à un tel gabarit, on augmente le filtrage opéré par le filtre post-amplificateur, on augmentera alors de façon inéluctable les pertes dans la bande de signal utile. Il faudra alors mettre plus de puissance sur l'amplificateur, ce qui le rendra alors moins compétitif qu'un amplificateur classique.

Et, ce problème d'élimination du bruit en dehors de la bande de signal utile est d'autant plus complexe à résoudre que les contraintes imposées par les normes de transmission, en termes de niveau d'énergie, sont différentes en fonction de la fréquence.

Ainsi, à titre d'exemple, si un téléphone mobile est destiné à fonctionner selon la norme de transmission W-CDMA, dont la bande utile de transmission se situe entre 1920 MHz et 1980 MHz, alors, le niveau de bruit en dehors de la bande utile ne devrait pas dépasser -117 dBm par hertz entre 925 MHz et 935 MHz et -129 dBm entre 935 MHz et 960 MHz, et ce afin de ne pas perturber les réceptions GSM.

Par ailleurs, le niveau de bruit ne devrait pas dépasser -121 dBm par hertz entre 1805 MHz et 1880 MHz afin de ne pas perturber les réceptions DCS.

L'invention vise à apporter une solution à ce problème.

L'invention a pour but de diminuer le bruit de quantification dans au moins une bande d'intérêt fréquentielle, et éventuellement plusieurs bandes d'intérêt fréquentielles, situées en dehors de la bande utile du signal, afin de satisfaire aux exigences des gabarits de bruit fixés par les normes de transmission, et ce tout en relâchant les contraintes sur le filtre post-amplificateur situé en aval des moyens d'amplification.

L'invention propose donc un dispositif d'amplification de puissance, comportant une entrée pour recevoir un signal ayant une bande fréquentielle utile, et des moyens d'amplification de puissance du type delta-sigma.

Selon une caractéristique générale de l'invention, les moyens d'amplification de puissance du type delta-sigma présentent un ordre supérieur ou égal à 1 dans la bande utile du signal et un ordre supérieur ou égal à 1 hors de ladite bande utile.

En d'autres termes, l'invention résout le problème de la diminution du bruit hors de la bande utile en modifiant l'architecture classique des moyens d'amplification du type delta-sigma. Plus précisément, le fait de prévoir un ordre supérieur ou égal à 1, et généralement supérieur à 1, dans la bande utile du signal, permet de régler la position des zéros de la fonction de transfert de bruit de façon à ajuster le rapport signal/bruit dans la bande utile.

Et, le fait de prévoir un ordre supérieur ou égal à 1 et généralement supérieur à 1, hors de la bande utile, permet d'ajuster la valeur de la ou des bandes fréquentielles d'intérêts, situées hors de cette bande utile, et pour lesquelles on souhaite minimiser le bruit de quantification.

Ainsi, puisqu'on élimine par construction même des moyens d'amplification, une partie du bruit située hors de la bande utile du signal, on relâche de ce fait les contraintes sur le filtrage post-amplificateur. Et, ce filtrage est très critique puisqu'il opère un compromis entre les pertes d'insertion dans la bande de signal utile et l'atténuation à l'extérieur de cette bande. Et, à titre indicatif, un dB de perte sur le signal transmis se traduit par une augmentation de la puissance de l'amplificateur et par conséquent une augmentation de la consommation de courant.

Par conséquent, diminuer le bruit de quantification à l'extérieur de la bande utile permet de réduire les besoins du filtrage post-amplificateur, et par conséquent les pertes dans la bande de transmission utile, ce qui va se traduire au final par un gain sur la consommation de courant.

Selon un mode de réalisation de l'invention, les moyens d'amplification de puissance comportent au moins un réseau sélecteur de fréquence accordé sur une fréquence située dans la bande utile, et au moins un réseau sélecteur de fréquence accordé sur une fréquence située hors de la bande utile.

Selon un mode de réalisation de l'invention, le dispositif d'amplification de puissance comporte en outre au moins un amplificateur de signal (gain de signal) connecté entre ladite entrée et les moyens d'amplification de puissance.

Ce nombre d'amplificateurs de signal (gains de signal), peut être égal à l'ordre global des moyens d'amplification de puissance, augmenté d'une unité.

La présence d'au moins un gain de signal, éventuellement programmable, permet déjà de réduire la dynamique d'entrée des moyens d'amplification, puisque le gain de signal agit uniquement sur le signal d'entrée.

Ceci étant la présence de plusieurs gains de signal, éventuellement programmables, donne plus de souplesse pour un contrôle du gain total des moyens d'amplification, qui est fixé en jouant sur la valeur des gains de signal.

Par ailleurs, la présence d'au moins deux gains de signal permet en outre d'ajuster les zéros de la fonction de transfert polynomial du signal. Puisque les zéros de la fonction de transfert du signal sont alors différents des zéros de la fonction de transfert du bruit, on peut également ajuster par la présence de ces gains de signal, des valeurs de fréquence hors de la bande utile pour lesquelles on souhaite éliminer du bruit sur le signal d'entrée. On réalise ainsi par construction même des moyens d'amplification de puissance, un filtrage du signal d'entrée hors de la bande utile, ce qui permet de relâcher les contraintes de filtrage sur les éléments situés en amont du dispositif d'amplification de puissance selon l'invention.

Le dispositif d'amplification de puissance selon l'invention est avantageusement réalisé sous la forme d'un circuit intégré.

L'invention propose également un composant d'un système de communication sans fil, comportant un dispositif d'amplification de puissance tel que défini ci-avant.

Ce composant peut être par exemple un téléphone mobile cellulaire, ou bien une station de base.

D'autres avantages et caractéristiques de l'invention apparaîtront à l'examen de la description détaillée de modes de réalisation, nullement limitatifs, et des dessins annexés sur lesquels :
- la figure 1 illustre de façon schématique la structure d'un téléphone mobile cellulaire selon l'invention,
- la figure 2 illustre un exemple de gabarit de bruit pour une transmission selon la norme CDMA,
- la figure 3 illustre de façon schématique un premier mode de réalisation d'un dispositif d'amplification de puissance selon l'invention, et,
- la figure 4 illustre schématiquement un deuxième mode de réalisation d'un dispositif d'amplification de puissance selon l'invention.

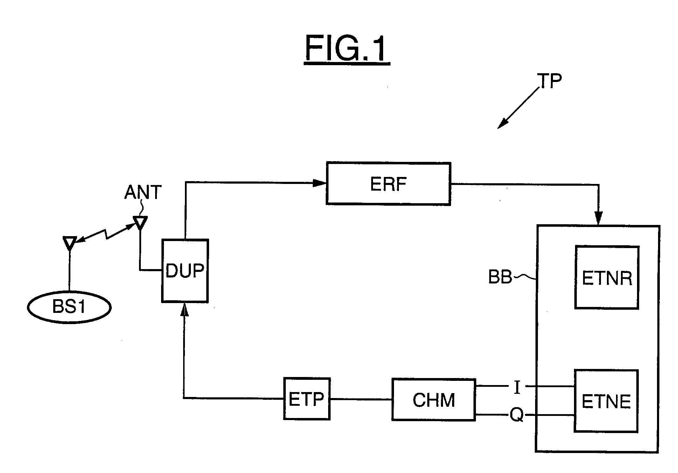

Sur la figure 1, la référence TP désigne un terminal distant, tel qu'un téléphone mobile cellulaire, qui est en communication avec une station de base BS1, par exemple selon un schéma de communication du type CDMA-FDD (par exemple norme UTRA-FDD).

Le téléphone mobile cellulaire comprend, de façon classique, un étage analogique radiofréquence ERF connecté à une antenne ANT par l'intermédiaire d'un duplexeur DUP, pour recevoir un signal d'entrée.

Classiquement, l'étage ERF comprend un amplificateur faible bruit et deux voies de traitement comportant des mélangeurs, des filtres et amplificateurs classiques. Les deux mélangeurs reçoivent respectivement de la part d'une boucle à verrouillage de phase deux signaux présentant mutuellement une différence de phase de 90°. Après transposition de fréquence dans les mélangeurs, les deux voies de traitement définissent respectivement deux flux I (flux direct) et Q (flux en quadrature) selon une dénomination bien connue de l'homme du métier.

Après conversion numérique dans des convertisseurs analogiques/numériques CAN, les deux flux I et Q sont délivrés à un étage de traitement de réception ETNR.

Cet étage de traitement ETNR comprend, de façon classique, un récepteur, communément désigné par l'homme du métier "récepteur Rake", suivi par des moyens classiques de démodulation qui effectuent la démodulation de la constellation délivrée par le récepteur Rake.

L'étage de traitement ETNR comprend également de façon classique un décodeur de source qui effectue un décodage de source bien connu par l'homme du métier.

Le bloc de traitement en bande de base BB comporte, outre l'étage de traitement ETNR, un étage de traitement d'émission ETNE qui effectue, de façon classique, notamment les traitements de codage de source, d'étalement des symboles, de modulation, pour délivrer les deux flux I et Q à une chaîne d'émission CHM de structure classique.

Cette chaîne d'émission CHM comporte notamment en tête, des convertisseurs numériques / analogiques, ainsi que des mélangeurs permettant d'effectuer une transposition de fréquence à la fréquence d'émission. Là encore, les signaux de transposition sont délivrés par une boucle à verrouillage de phase (non représentée ici à des fins de simplification) contrôlée également par des moyens de contrôle automatique de fréquence incorporés dans l'étage ETNE.

La chaîne CHM est classiquement suivie d'un étage amplificateur de puissance ETP connecté à l'antenne par le duplexeur DUP.

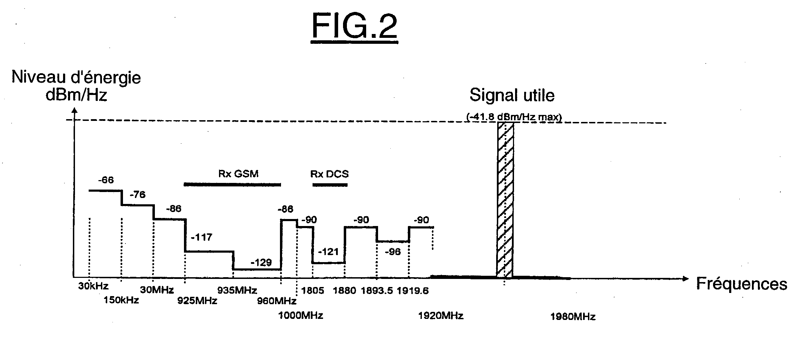

Le groupe de normalisation 3GPP définit dans la spécification TS25 101 des valeurs de niveau de bruit à ne pas dépasser au niveau du connecteur d'antenne. Ces niveaux de bruit se traduisent ainsi par le gabarit en émission illustrée sur la figure 2 et valable pour une émission selon la norme W-CDMA.

On remarque sur ce gabarit, qu'alors que la bande utile de transmission se situe ici entre 1920 MHz et 1980 MHz, il convient de ne pas dépasser un niveau de bruit égal à -117 dBm par hertz entre 925 Mhz et 935 MHz et un niveau de -129 dBm par hertz entre 935 MHz et 960 MHz. Ces valeurs sont fixées de façon à ne pas perturber des réceptions GSM effectuées par d'autres téléphones.

De même, en dehors de cette bande utile, le niveau de bruit ne doit pas dépasser -121 dBm par hertz entre 1805 MHz et 1880 MHz afin de ne pas perturber une réception selon la norme DCS.

Le dispositif d'amplification de puissance selon l'invention va alors être architecturé de façon à satisfaire aux exigences du rapport signal/bruit dans la bande utile du signal, ainsi qu'aux exigences de niveau de bruit en dehors de la bande utile.

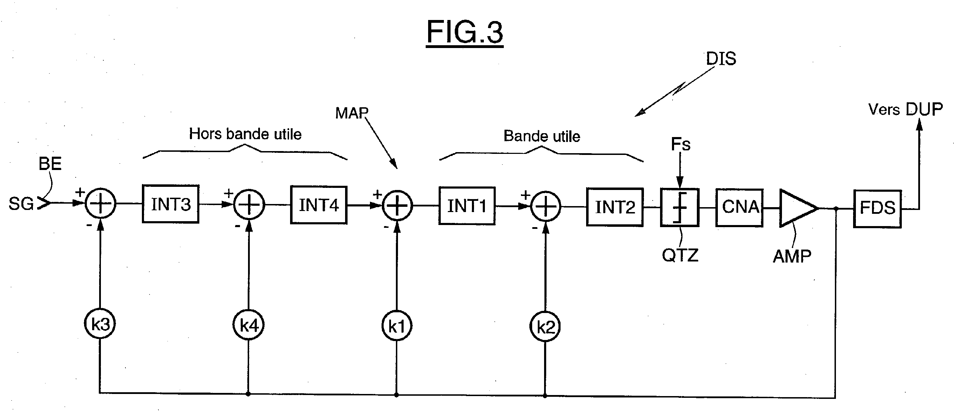

Plus précisément, comme illustré sur la figure 3, le dispositif d'amplification de puissance DIS comporte une borne d'entrée BE recevant le signal SG à amplifier, suivie des moyens d'amplification de puissance MAP du type delta-sigma.

Plus précisément, le signal SG, présent à la borne d'entrée BE et provenant ici d'un mélangeur ayant transposé le signal SG dans le domaine radiofréquence, est traité par une succession d'additionneurs/soustracteurs et de moyens d'intégration INT1-INT3 respectivement formés ici de réseaux sélecteurs de fréquence.

Le signal délivré à la sortie du réseau sélecteur de fréquence INT2 est ensuite quantifié sur un bit dans un moyen de quantification QTZ.

Le signal, de forme d'onde carrée, délivré par le moyen de quantification QTZ est ensuite amplifié, après conversion numérique analogique CNA, dans un amplificateur de puissance AMP fonctionnant en classe E (c'est-à-dire sur des signaux carrés).

La sortie de l'amplificateur est rebouclée sur les entrées des additionneurs/soustracteurs par quatre gains continus respectivement référencés dans cet exemple k1-k4.

La sortie de l'amplificateur AMP est également reliée à l'entrée d'un filtre post-amplificateur FDS, qui est un filtre passe-bande, dont la sortie est reliée au duplexeur DUP.

Les moyens d'amplification de puissance MAP du type delta-sigma, ont ici, pour des raisons de simplification de la figure 3, un ordre global égal à 4 (puisque le nombre d'intégrateurs est égal à 4).

Les deux réseaux sélecteurs de fréquence INT1 et INT2 sont ici des réseaux inductifs capacitifs respectivement accordés sur des fréquences situées dans la bande utile de signal, c'est-à-dire entre 1920 et 1980 MHz dans le cas présent.

Plus précisément, le réseau INT1 peut être accordé par exemple sur la fréquence de 1940 MHz tandis que le réseau INT2 peut être accordé sur la fréquence de 1960 MHz.

D'une façon générale, les fréquences de résonance des différents réseaux sélecteurs de fréquences fixent les zéros de la fonction de transfert du bruit, c'est-à-dire les fréquences auxquelles on élimine le bruit de quantification.

Les deux zéros de la fonction de transfert, correspondant aux deux fréquences de résonance des réseaux INT1 et INT2 ont pour but de satisfaire aux exigences de deux rapport signal/bruit dans la bande utile de transmission du signal.

Par ailleurs, les deux réseaux sélecteurs de fréquence INT3, INT4 sont accordés sur des fréquence situées hors de la bande utile. Chacun de ces réseaux permet donc d'éliminer le bruit de quantification à la fréquence à laquelle il est accordé.

Dans le cas présent, les réseaux INT3 et INT4 peuvent être respectivement accordés sur des fréquences égales à 930 et 950 MHz, ce qui permet de réduire le niveau de bruit dans la bande de réception GSM comprise entre 925 MHz et 960 MHz (figure 2).

Les pôles de la fonction de transfert sont fixés par les gains de retour continus k1-k4 et sont placés de façon à stabiliser l'ensemble du système.

Ainsi, en limitant le niveau de bruit à des fréquences prédéterminées en dehors de la bande utile du signal, et directement au niveau du moyen d'amplification de puissance MAP, l'invention permet de relâcher la contrainte de filtrage sur le filtre post-amplificateur , typiquement de l'ordre de 20 décibels.

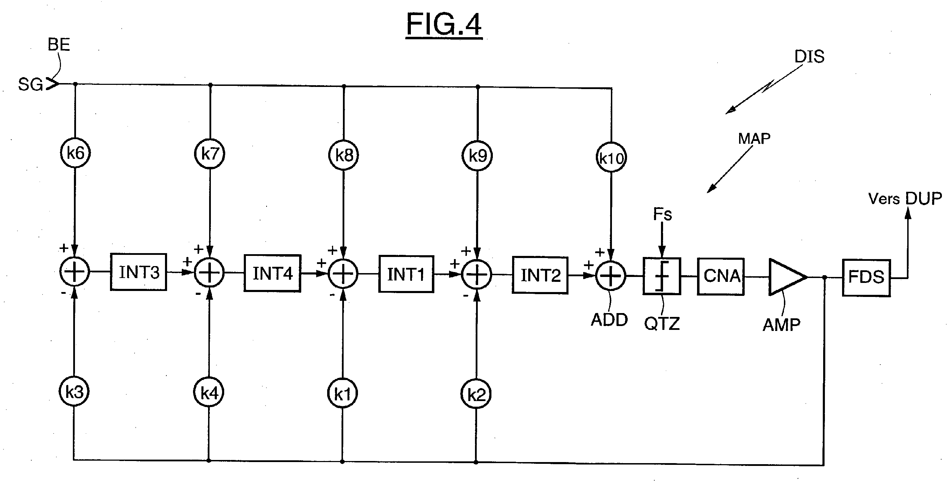

On se réfère maintenant plus particulièrement à la figure 4 qui illustre un autre mode de réalisation d'un dispositif d'amplification de puissance selon l'invention.

Dans ce mode de réalisation, le dispositif d'amplification de puissance DIS se distingue de celui illustré sur la figure 3 du fait qu'il est prévu au moins un gain de signal (amplificateur de signal) disposé entre la borne d'entrée BE et les moyens d'amplification de puissance MAP. En l'espèce, il est prévu 5 gains de signal k6-k10, respectivement connectés entre la bande d'entrée BE et les additionneurs/soustracteurs disposés en amont des réseaux INT1-INT4 ainsi qu'entre la borne d'entrée BE et un additionneur supplémentaire ADD disposé entre le réseau sélecteur de fréquence INT2 et le moyen de quantification QTZ.

Un tel mode de réalisation donne un degré de liberté supplémentaire pour fixer les zéros de la fonction de transfert du signal.

En effet, les zéros et les pôles de la fonction de transfert du bruit sont fixés par les fréquences des réseaux sélecteurs de fréquences ainsi que par les gains de retour k1-k4. Par ailleurs, les pôles de la fonction de transfert du signal sont identiques aux pôles de la fonction de transfert du bruit.

Si l'on ne prévoit pas au moins deux gains de signal disposés entre la borne d'entrée BE et l'entrée du moyen de quantification QTZ (directement ou indirectement par l'intermédiaire des réseaux sélecteurs de fréquence) alors les zéros de la fonction de transfert du signal seraient automatiquement fixés, une fois fixés les gains de retour ainsi que les fréquences d'accord des réseaux sélecteurs de fréquence.

Mais, en présence d'au moins deux gains de signal, on peut alors ajuster la localisation des zéros de la fonction de transfert de signal.

Et une localisation des zéros de la fonction de transfert de signal à l'extérieur de la bande utile ( à partir des valeurs relatives des gains de signal ) permet d'assurer un filtrage du signal d'entrée SG et d'éliminer du bruit parasite à des fréquences prédéterminées situées en dehors de la bande utile. On peut ainsi relâcher la contrainte de filtrage sur les éléments de la chaîne d'émission situés en amont du dispositif d'amplification de puissance.

Par ailleurs, en jouant sur la valeur absolue des gains de signal on peut ajuster le gain de l'amplificateur, en particulier dans la bande de transmission utile, et ce sans dégrader le rapport signal/bruit.

Par ailleurs, puisque ces gains n'agissent que sur le signal d'entrée, on réduit ainsi la dynamique d'entrée des moyens d'amplification de puissance.

Ces gains de signal peuvent être éventuellement programmables.

Par ailleurs, la présence de tels gains de signal permet de réduire la puissance de sortie du mélangeur disposé en amont du dispositif d'amplification de puissance. Ainsi, 15 dB de gain sur le signal permet une diminution de 15 dB de la puissance maximale nécessaire en sortie du mélangeur.

Enfin, ainsi, les exigences de linéarité du système sont les plus contraignantes sur les étages d'entrée des moyens d'amplification de puissance, c'est à dire les étages correspondant aux gains k3 et k6. Et, plus on se déplace vers les moyens de quantification, plus on relâche les contraintes sur les performances de linéarité des blocs intermédiaires.

## Revendications

**1.** Dispositif d'amplification de puissance, comportant une entrée pour recevoir un signal ayant une bande fréquentielle utile, et des moyens d'amplification de puissance du type delta-sigma, **caractérisé par le fait que** les moyens d'amplification de puissance du type delta-sigma (MAP) présentent un ordre supérieur ou égal à un dans la bande utile du signal et un ordre supérieur ou égal à un hors de ladite bande utile.

**2.** Dispositif selon la revendication 1, **caractérisé par le fait que** les moyens d'amplification de puissance (MAP) comportent au moins un réseau sélecteur de fréquence (INT1, INT2) accordé sur une fréquence située dans la bande utile, et au moins un réseau sélecteur de fréquence (INT3, INT4) accordé sur une fréquence située hors de la bande utile.

**3.** Dispositif selon l'une des revendications précédentes, **caractérisé par le fait qu'**il comporte au moins un amplificateur de signal (k6, k10) connecté entre ladite entrée et les moyens d'amplification de puissance.

**4.** Dispositif selon la revendication 3, **caractérisé par le fait qu'**il comprend au moins deux amplificateurs de signal (k6, k10) connectés entre ladite entrée et les moyens d'amplification de puissance.

**5.** Dispositif selon la revendication 4, **caractérisé par le fait qu'**il comporte un nombre d'amplificateurs de signal égal à l'ordre global des moyens d'amplification de puissance, augmenté d'une unité.

**6.** Dispositif selon la revendication 4 ou 5, **caractérisé par le fait que** les valeurs relatives des gains des amplificateurs de signal sont ajustées de façon à localiser les zéros de la fonction de transfert de bruit à l'extérieur de la bande utile.7. Dispositif selon l'une des revendications 3 à 6, **caractérisé par le fait que** les amplificateurs de signal sont à gain programmable.

**8.** Dispositif selon l'une des revendications précédentes, **caractérisé par le fait qu'**il est réalisé sous la forme d'un circuit intégré.

**9.** Composant d'un système de communication sans fil, **caractérisé par le fait qu'**il comporte un dispositif d'amplification de puissance selon l'une des revendications 1 à 8.

**10.** Composant selon la revendication 9, **caractérisé par le fait qu'**il forme un téléphone mobile cellulaire.
